# EUROPÄISCHE PATENTSCHRIFT

(11) **EP 0 467 136 B1**
(45) Veröffentlichungstag und Bekanntmachung des Hinweises auf die Patenterteilung: **17.12.1997**
(21) Anmeldenummer: 91110805.8
(22) Anmeldetag: 29.06.1991
(51) Int. Cl.: G03F 7/11

(54) **Photopolymerisierbare Druckplatte für Flexodruck**
Photopolymerizable printing plate for flexographic printing
Cliché photopolymérisable pour l'impression flexographique

(30) Priorität: 19.07.1990 DE 4022978
(43) Veröffentlichungstag der Anmeldung: 22.01.1992
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Abele, Werner, Dr., W-6078 Neu-Isenburg (DE); Schumacher, Wilfried, W-6453 Seligenstadt 2 (DE); Schober, Manfred, Dr., W-6050 Offenbach (DE)

(56) Entgegenhaltungen:
- EP-A- 0 185 337
- EP-A- 0 322 585
- DE-C- 2 215 090
- CHEMICAL ABSTRACTS, vol. 101, no. 12, 17 September 1984 Columbus, Ohio, USA X. WANG et al: "Technological development of thermoplastic SBS styrene-butadiene- styrene elastomers. II. Synthesis and properties of radial SBS block copolymers." Seite 75; ref. no. 92533F

## Beschreibung

Die Erfindung betrifft photopolymerisierbare Druckplatten, deren wesentliche Bestandteile eine photopolymerisierbare Schicht und eine auf dieser Schicht aufgebrachte elastomere Schicht sind, wobei die elastomere Schicht als Bindemittel mindestens ein polystyrolhaltiges Blockcopolymer gemäß dem kennzeichnenden Teil von Anspruch 1 enthält. Solche Druckplatten zeichnen sich durch eine kostengünstigere Herstellung und einfachere und schnellere Verarbeitung aus.

Es ist bekannt, für die Herstellung von Druckformen für den Flexodruck photopolymerisierbare Aufzeichnungsmaterialien zu verwenden, bei denen die Druckoberfläche durch bildmäßiges Belichten einer lichtempfindlichen Schicht und anschließendes Entfernen der unbelichteten Schichtteile erzeugt wird. Beispiele für solche Aufzeichnungsmaterialien finden sich in den folgenden Patentschriften: DE-C3 22 15 090; US-A 4,266,005; US-A 4,320,188, US-A 4,126,466 und US-A 4,430,417. Solche photopolymerisierbaren Druckplatten setzen sich üblicherweise aus einem Schichtträger, ggf. einer Haft-oder anderen Unterschicht, einer photopolymerisierbaren Schicht, die mindestens ein polymeres Bindemittel, mindestens ein durch aktinische Strahlung additionspolymerisierbares, ethylenisch ungesättigtes Monomer und einen Photoinitiator oder ein Photoinitiatorsystem enthält, und einer Deckschicht zusammen. Zwischen der photopolymerisierbaren Schicht und der Deckschicht, die vor der Belichtung entfernt wird, befindet sich überlicherweise ein flexibler reißfester Polymerfilm. Diese Polymerschicht ermöglicht eine klebfreie Negativauflage bei der Belichtung der Druckplatte und einen guten Kontakt der Bildvorlage zur Druckplatte, da eine Blasenbildung bei der Auflage vermieden wird. Beispiele für solche Schutzschichten finden sich z.B. auch in der US-A 4,423,135 und der DE-C 23 37 645.

Aus der EP-A 0 322 585 sind Druckplatten aus einer lichtempfindliche Schicht mit speziellen Monomermischungen bekannt, die als Bindemittel thermoplastisch elastomere Blockcopolymere, bevorzugt lineare und radiale Blockcopolymere mit Polystyrolendblöcken, die auch ölverstreckt sein können, enthält. Bevorzugt werden als Mittelblöcke Polybutadien und Polyisopren verwendet. Der Polystyrolgehalt beträgt üblicherweise 10-40%. Auch solche Druckplatten werden wie allgemein üblich durch eine, die lichtempfindliche Schicht und die Fotovorlage schützende Deckschicht bildmäßig belichtet, und die Deckschicht wird nach der Belichtung entfernt.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird.

Aus der EP-B1 00 84 851 ist ein Herstellungsverfahren für eine mehrschichtige, photopolymerisierbare Druckplatte bekannt, die zwischen der flexiblen, reißfesten Polymerschicht und der photopolymerisierbaren Schicht eine elastomere Schicht besitzt, die ein elastomeres Bindemittel, ggf. ein zweites Bindemittel, ggf. einen Farbstoff, ggf. ein oder mehrer Monomere und ggf. einen Photoinitiator enthält.

Aus der EP-A 0 185 337 ist ein solches Herstellungsverfahren bekannt, bei dem mindestens auch die elastomere Schicht eines mehrschichtigen Deckelements durch Extrudieren und Kalandrieren hergestellt wird. Auch die Druckplatten der EP-A 0 185 337 werden wie allgemein üblichen durch eine polymere Schutzschicht hindurch bildmäßig belichtet.

Eine Auflage der Bildvorlage auf die elastomere Schicht ist ggf. möglich, wenn die Deckschicht, die vor der Belichtung entfernt wird, mit einer speziellen Silikonschicht versehen ist, die zunächst teilweise auf der elastomeren Schicht verbleibt. Dieses Verfahren ist aber umständlich und nur bei speziellen Deckschichten und elastomeren Zwischenschichten möglich. Auch ergeben sich aus der Verwendung solcher Silikonschichten Nachteile bei der Auswaschentwicklung, da die Silikone im Entwicklerlösungsmittel unlöslich sind und zu einem Verkleben der Auswaschbürsten führen.

Ein Nachteil der beschriebenen photopolymerisierbaren Druckplatten ist, daß die biegsame, flexible Polymerschicht, die zur klebfreien, blasenfreien Negativauflage benötigt wird, die Entwicklung der belichteten Platten erschwert. Durch ihr unterschiedliches Lösungsverhalten im Vergleich zu den Komponenten der photopolymerisierbaren Schicht ist entweder ein zusätzlicher Entwicklungsschritt, wie ein vorheriges Abziehen der Polymerschicht oder eine Behandlung mit einem speziellen Lösungsmittel, oder der Zusatz von Additiven zum eigentlichen Entwicklungslösungsmittel erforderlich. Manche dieser Schutzschichten quellen auch nur in den Entwicklungslösungsmitteln und können nur durch intensive mechanische Behandlung entfernt werden.
Zudem benötigt jede Druckplatte eine speziell auf ihre photopolymerisierbare Schicht abgestimmte polymere Schutzschicht, d.h. die Zusammensetzung dieser Polymerschicht muß der jeweiligen photopolymerisierbaren Druckplatte angepaßt werden. Dies führt aber zu hohen Entwicklungs- und Lagerungskosten für die verschiedenen Schichttypen.
Hierdurch und durch die zusätzlich benötigten Verfahrensschritte zur Herstellung und zum Aufbringen der Polymerschicht auf die photopolymerisierbare Schicht erhöhen sich die Herstellungskosten der Druckplatten und der ganze Produktionsprozeß wird langwieriger. Die grundlegende Unverträglichkeit der üblicherweise als Schutzschichten verwendeten Polyamidfilme und der in Flexodruckplatten als Bindemittel häufig verwendeten elastomeren Blockcopolymere führt außerdem zu permanenten Delaminierungsproblemen zwischen Schutzschicht und photopolymerisierbarer Schicht.

Der vorliegenden Erfindung lag daher die Aufgabe zugrunde, die o.g. Probleme und Nachteile zu beseitigen und eine photopolymerisierbare Druckplatte zur Verfügung zu stellen, deren Oberfläche nicht klebrig ist, so daß eine direkte Auflage einer Bildvorlage auf die Druckplatte möglich ist, ohne Beschädigung oder Verschmutzung der Bildvorlage. Gleichzeitig muß ein guter Kontakt ohne Blasenbildung zwischen der Bildvorlage und der Druckplatte gewährleistet sein. Auch soll die Druckplatte einfacher und kostengünstiger herzustellen und zu verarbeiten sein. Desweiteren sollte die übliche Auswaschentwicklung mit gängigen Lösungsmitteln ohne Zusatz von Additiven möglich sein. Auch die Ozonstabilität der Druckformen sollte erhöht werden. Gleichzeitig sollten andere Eigenschaften der photopolymerisierbaren Druckplatten nicht negativ beeinflußt werden, z.B. sollte eine Verringerung der Photoempfindlichkeit vermieden werden. Außerdem dürfen die Flexodruckformen in den Druckfarben nicht quellen, da dies zu einem unerwünschten Punktzuwachs und damit zu fehlerhaften Druckergebnissen führt.

Diese Aufgabe wurde überraschenderweise gelöst durch eine photopolymerisierbare Druckplatte im wesentlichen bestehend aus a) einem Schichtträger, b) einer photopolymerisierbaren Schicht, enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem, c) einer elastomeren Schicht, enthaltend mindestens ein thermoplastisch elastomeres Blockcopolymer, und d) einer Deckfolie.

Die Erfindung ist dadurch gekennzeichnet, daß die elastomere Schicht c) als Bindemittel ein oder mehrere thermoplastisch elastomere Blockcopolymere enthält, die aufgebaut sind aus mindestens einem Polystyrolblock und mindestens einem Polybutadien-, Polyethylen- und/oder Polypropylenblock, wobei der Polystyrolgehalt des Bindemittels oder des Bindemittelsgemischs 10 bis 35 Gew.% beträgt, die Lösungsviskosität der Blockcopolymere für eine 5,23%ige Lösung in Toluol ≥ 5 mm²/s und der Schmelzindex gemessen nach ASTM D 1238 P ≤ 10 g/10 min ist.

Die erfindungsgemäßen Druckplatten weisen eine gute Haftung der elastomeren Schicht an der photopolymerisierbaren Schicht auf, so daß keine Delaminierungsprobleme auftreten. Die aus den erfindungsgemäßen Druckplatten hergestellen Druckformen für den Flexodruck zeigen gute Druckeigenschaften, die mit den herkömmlichen Druckformen vergleichbar sind. Die Druckformoberfläche ist resistent gegen Flexodruckfarben, auch bei hohen Auflagen. Ein Aufquellen der Oberfläche wurde nicht beobachtet und die Druckqualität war gleichbleibend gut.

Ein besonderer Vorteil ist, daß die erfindungsgemäßen Druckplatten eine gute Flexibilität aufweisen und die Oberfläche nicht spröde ist und auch bei hoher Belastung der Druckplatten zu keinerlei Faltenbildung neigt.

Durch den Einsatz von nur einem Entwicklungslösungsmittel ist eine einfachere und sichere Qualitätsüberwachung bei der Auswaschentwicklung der belichteten Druckplatte möglich. Auch die Auswaschgeschwindigkeit kann gegenüber üblichen Druckplatten, die mit einer Polyamidschicht versehen sind, gesteigert werden.

Die erfindungswesentlichen thermoplastisch elastomeren Blockcopolymere der elastomeren Schicht c) sind aus mindestens einem Polystyrolblock und mindestens einem Polybutadien-, Polyethylen- und/oder Polypropylenblock aufgebaut. Bevorzugt werden Polystyrol-Polybutadien- oder Polystyrol-Polybutadien-Polystyrol-Blockcopolymere verwendet, insbesondere radiale Blockcopolymere, wie z.B. (Polystyrol-Polybutadien)₄-Si.

Der Polystyrolgehalt des Bindemittels oder des Bindemittelgemischs der elastomeren Schicht c) beträgt 10 bis 35 Gew.%, bevorzugt 15 bis 30 Gew.%.

Die erfindungswesentlichen Blockcopolymere sind außerdem gekennzeichnet durch eine Lösungsviskosität (gemessen als 5,23%ige Lösung in Toluol ) von ≥5 mm²/s, insbesonders ≥ 10 mm²/s, und durch einen Schmelzindex (gemessen nach ASTM D 1238 P (5 kg/190 °C) von ≤ 10 g/10 min, insbesondere ≤ 2 g/10 min.

Besonders bevorzugt werden als Bindemittel der elastomeren Schicht c) radiale (Polystyrol-Polybutadien)₄-Si-Blockcopolymere mit einem Polystyrolgehalt von 18 bis 23 Gew.%, einer Lösungsviskosität von ≥ 15 mm²/s und einem Schmelzindex von ≤ 1,5 g/min verwendet.

In einer besonders vorteilhaften Ausführungsform der vorliegenden Erfindung wird neben den beschriebenen Blockcopolymeren ein Polymer mit einer Trübung von ≤ 20 % bevorzugt ≤ 12 % (gemessen nach ASTM D 1003) und einer Rockwell Härte von ≥ 50, bevorzugt ≥ 80 (gemessen nach ASTM D 785) verwendet. Der Gehalt der elastomeren Schicht c) an diesem Polymer liegt dabei bevorzugt zwischen 1,5:1 bis 1:1,5. Besonders bevorzugt werden aber 1:1 Mischungen eingesetzt. Beispiele für solche Polymere sind Copolymere aus Acrylnitril, Butadien und Methylmethacrylat bzw. solche, die zusätzlich noch Styrol enthalten. Der Acrylnitrilgehalt sollte zwischen 5 bis 35 Gew. %, bevorzugt zwischen 5 bis 20 Gew. %, liegen. Insbesondere ein Methylmethacrylat/Acrylnitril/Butadien/Styrol-Tetrapolymer (46/9/14/31) mit einer Trübung von 10 % und einer Rockwell Härte von 103 ist geeignet.

Desweiteren können übliche Zusätze wie z.B. Farbstoffe, Füllstoffe, Weichmacher, Lösungsmittel, etc. in der elastomeren Schicht verwendet werden.

Zur Verbesserung der Druckqualität mit wäßrigen und alkoholischen Druckplatten können der elastomeren Schicht 5 - 30 Gew.%, bevorzugt 15 - 25 Gew.%,eines Polymers mit der folgenden Struktureinheit A 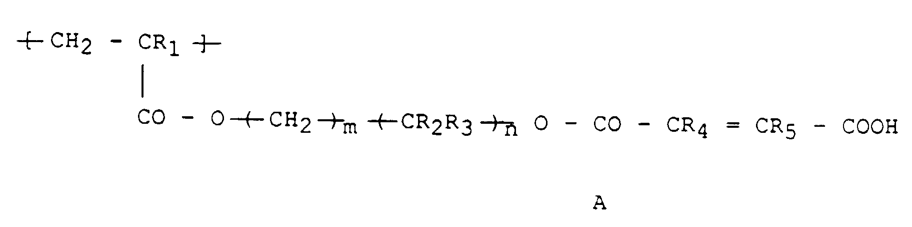 zugegeben werden, worin R₁ für H und CH₃, R² und R³ unabhängig voneinander für H und substituierte oder unsubstituierte Alkyl- oder Arylgruppen und R₄ und R₅ unabhängig voneinander für H und substituierte oder unsubstituierte Alkygruppen stehen können und m und n Werte von 0 bis 10 annehmen können, wobei die Summe aus m und n gleich 2 bis 20 sein kann.

Auch durch die Zugabe von 5 - 30, bevorzugt 15 - 25 Gew.% eines Umsetzungsproduktes eines Epoxidharzes mit einem teilweise mit Polyolen veresterten Addukt von ungesättigten Mono- und/oder Polycarbonsäuren oder deren Anhydriden mit Kolophoniumharzen kann der gleiche Effekt erzielt werden.

Die elastomere Schicht c) sollte eine Dicke von 0,01 bis 0,5 mm, bevorzugt 0,025 bis 0,12 mm, haben.

Die Schicht kann durch Gießen aus Lösungsmitteln wie Toluol, Aceton, Methylenchlorid, Perchlorethylen, Methylethylketon, Methylisobutylketon oder Mischungen etc. oder durch Extrusionsbeschichtung direkt auf die Deckfolie d), z.B. eine Polyethylenterephthalatfolie, aufgebracht werden. Wenn das Tetrapolymer nicht wie üblich gemeinsam mit anderen Komponenten zur Herstellung der Gießlösung für die elastomere Schicht c) in einem entsprechenden Lösungsmittel aufgelöst wird, sondern vorher separat im Lösungsmittel gelöst und diese Lösung vorfiltriert wird und dann diese Lösung zu einer Lösung der übrigen Gießkomponenten gegeben wird, so ist eine erhebliche Verbesserung der Gießqualität zu erzielen.

Die photopolymerisierbare Schicht b) der erfindungsgemäßen Druckplatten enthält mindestens ein elastomeres Bindemittel. Geeignet sind z.B. Blockcopolymere wie sie in DE-C3 22 15 090; US-A 4,320,188 und US-A 4,162,919 beschrieben werden. Bevorzugt werden Blockcopolymere vom A-B-A-Typ, die einen elastomeren Block, z.B. Polybutadien oder Polyisopren, zwischen zwei thermoplastischen Blöcken, z.B. Polystyrol, besitzen. Besonders bevorzugt werden lineare und radiale Blockcopolymere mit Polystyrol-Endblöcken verwendet, wie z.B. Polystyrol-Polyisopren-Polystyrol,, (Polystyrol-Polybutadien)₄-Si oder (Polystyrol-Polyisopren)₄-Si.
Das mittlere Molekulargewicht der Blockcopolymere sollte zwischen 80 000 und 300 000 liegen, bevorzugt zwischen 100 000 und 250 000. Der Polystyrolanteil sollte 10 bis 40 Gew.% betragen, bevorzugt 15 bis 30 Gew.%.

Die photopolymerisierbare Schicht b) enthält außerdem mindestens ein durch aktinische Strahlung additionspolymerisierbares, ethylenisch ungesättigtes Monomer.

Hierbei kann es sich sowohl um Monomere mit einer ethylenisch ungesättigten Gruppe als auch um solche mit mehreren ethylenisch ungesättigten Gruppen handeln. Die Monomere können allein oder auch in Kombination miteinander eingesetzt werden. Bevorzugt werden Monomermischungen aus einfach ungesättigten Acrylaten und/oder Methacrylaten und mehrfach ungesättigten Acrylaten und/oder Methacrylaten verwendet. Solche Monomermischungen werden in der DE-C1 37 44 243 beschrieben.

Als Beispiel seien genannt; Octylacrylat, Isodecylacrylat, Isodecylmethacrylat, 2-Hexyloxyethylacrylat, 1,4-Butandioldiacrylat, 1,6-Hexandioldiacrylat, 1,6-Hexandioldiacrylat, Trimethylolpropantriacrylat.

Außerdem enthält die photopolymerisierbare Schicht b) einen Photoinitiator oder ein Photoinitiatorsystem, z.B.: α-Methylbenzoin, Benzophenon, Benzil-dimethyl-ketal oder Ethylanthrachinon/4,4'-Bis-(dimethylamino)-benzophenon. Ferner kann die photopolymerisierbare Schicht b) weitere Zusätze enthalten, wie z.B. Füllstoffe, Farbstoffe, Antioxidantien und Plastifizierungsmittel wie sie in EP-B1 00 84 851 genannt werden. Bevorzugt werden 0 - 30 Gew.% an Plastifizierungsmittel z.B. auf der Basis von Polystyrol bzw. Polybutadien und mit einem mittleren Molekulargewicht zwischen 1 000 und 10 000 verwendet.
Die photopolymerisierbare Schicht b) enthält allgemein 65 - 95 Gew.% Bindemittel, 5 - 30 Gew.% Monomer oder Monomermischung und 0,5 - 5 Gew.% Initiator.

Als Schichtträger a) eignen sich z.B. Aluminium, Stahl oder Kunststoffolien. Bevorzugt werden Polyesterfolien, die ggf. mit einer Haftschicht und/oder Antihaloschicht versehen sein können. Besonders geeignet sind Polyethylenterephthalatfolien.

Die erfindungsgemäßen, photopolymerisierbaren Druckplatten werden bevorzugt nach dem in der EP-B1 00 84 851 beschriebenen Verfahren hergestellt. Hierbei wird eine vorher extrudierte photopolymerisierbare Masse in den Spalt eines Kalanders eingeführt und zwischen einen Träger und ein Deckelement, bestehend aus einer Deckfolie d) und der erfindungsgemäßen Schicht c) kalandriert, wodurch eine photopolymerisierbare Schicht gebildet wird, die auf ihrer einen Seite an den Schichtträger und auf der anderen Seite an die elastomere Schicht c) des Deckelements angrenzt.

Die so hergestellte photopolymerisierbare Druckplatte wird abgekühlt und ggf. einer Vorbelichtung mit aktinischer Strahlung durch den Schichtträger hindurch unterworfen. Dann wird üblicherweise die Deckfolie entfernt, ein bildtragendes Transparent auf die photopolymerisierbare Druckplatte aufgelegt und durch dieses mit aktinischer Strahlung belichtet. Daraufhin werden die unvernetzten Bereiche der photopolymerisierbaren Schicht b) und der elastomeren Schicht c) durch Auswaschen mit einem Entwicklerlösungsmittel entfernt. Hierfür eignen sich besonders organische Lösungsmittel wie chlorierte Kohlenwasserstoffe, z.B. 1,1,1-Trichlorethan, oder gesättigte oder aromatische Kohlenwasserstoffe. Bevorzugt werden die Lösungsmittel der deutschen Patentanmeldung P 38 28 551.7 verwendet. Zur Entwicklung kann das Lösungsmittel in beliebiger Weise aufgebracht werden, z.B. durch Gießen, Tauchen, Spritzen oder Walzenauftrag. Durch Bürsten wird die Entfernung der nicht vernetzten Schichtteile erleichtert. Nach dem Trocknen der so erhaltenen Druckformen bei 40 bis 75 °C können diese in beliebiger Reihenfolge nachbelichtet und/oder zur Herstellung einer klebfreien Oberfläche z.B. mit einer freies Halogen enthaltenden Lösung behandelt werden.

Die in den folgende Beispielen angegebenen Prozente und Teile beziehen sich, soweit nicht anders angegeben, auf das Gewicht.

### Beispiel 1 (Vergleichsbeispiel)

| | |
|---|---|
| Polystyrol-Polyisopren-Polystyrol Blockcopolymer 15 % Polystyrol, Brookfield Viskosität 1600 mPa s (25%ig in Toluol) | 67,4 % |
| Methylmethacrylat/Acrylnitril/Butadien/Styrol | 31,3 % |
| Tetrapolymer, 46/9/14/31 | |
| Acid Blue (C.I. 13390) | 1,3 % |

Zur Herstellung eines mehrschichtigen Deckelements wurden der Farbstoff und das Tetrapolymer bei 116° C zusammengeknetet und dann extrudiert und granuliert. Dieses Gemisch und die übrigen Inhaltsstoffe der elastomeren Schicht c) wurden dann zu einer 15%igen Lösung in Methylenchlorid verarbeitet. Diese Gießlösung wurde mittels eines Extrusionsschlitzgießers mit einer Spaltbreite von 0,38 mm auf eine nicht beschichtete Polyethylenterephthalatunterlage, wie in EP-B1 00 84 851 Beispiel 1 beschrieben, aufgetragen, getrocknet und mit einer siliconbeschichteten Polyethylenterephthalatschutzschicht versehen.Die Trockenschichtdicke betrug 0.051 mm. Zur Herstellung einer Flexodruckplatte wurde analog EP-B1 00 84 851, Beispiel 1, eine photopolymerisierbare Mischung aus 1,4 Teilen 2,2-Dimethoxy-2-phenylacetophenon, 5,3 Teilen Hexamethylenglykoldiacrylat, 3,7 Teilen Hexamethylenglykoldimethacrylat, 0,166 Teilen 2,6-Di-tert-butyl-p-kresol, 0,001 Teilen Hydrochinon, 0,003 Teilen roter Farbstoff (C.I. 109), 0,13 Teilen Hydroxyethylmethacrylat, 82,3 Teilen Polystyrol-Polyisopren-Polystyrol Blockcopolymer (15% Polystyrol, MG 150 000), 6 Teilen α-Methylstyrol/Vinyltoluol-Harz und 1 Teil mikrokristallines Kohlenwasserstoffwachs in einem Zweischneckenextruder hergestellt, extrudiert und zwischen eine Polyethylenterephthalatträgerschicht und die elastomere Schicht c) des o.g. Deckelements, nachdem die Polyethylenterephthalatschutz-schicht entfernt war, kalandriert. Nach dem Abkühlen, der vollflächigen Rückseitenbelichtung durch die Trägerschicht und dem Entfernen der Polyethylenterephthalatdeckschicht wurde ein bildtragendes Transparent auf die Druckplattenoberfläche aufgelegt und hierdurch die Druckplatte 6 Minuten mit aktinischer Strahlung belichtet. Die Bildvorlage konnte nur unter großen Schwierigkeiten von der klebrigen Druckplatte entfernt werden, wobei große Teile der Oberflächenschicht an der Bildvorlage haften blieben, so daß diese unbrauchbar wurde. Drucktests konnten mit dieser Druckform nicht durchgeführt werden, da die Druckoberfläche zu stark beschädigt war. Die Entwicklung der photopolymerisierten Druckplatte erfolgte durch Auswaschen mit Tetrachlorethylen, wobei die Polyamidschicht und die unbelichteten Teile der photopolymerisierbaren Schicht b) und der elastomeren Schicht c) entfernt wurden. Anschließend wurde die Flexodruckform analog zu EP-B1 00 84 851 Beispiel 1 getrocknet, mit wäßriger Hypochloritlösung behandelt und nachbelichtet.

### Beispiel 2

### Zusammensetzung der elastomeren Schicht c)

| | |
|---|---|
| Radiales (Polystyrol-Polybutadien) ₄-Si-Blockcopolymer, 20 % Polystyrol, Lösungsviskosität 19 mm²/s (5,23%ig in Toluol), Schmelzindex < 0,5 g/10 min (gemäß ASTM D 1238 P) | 98,2 % |
| Ein in Didecylphthalat dispergiertes Cu-Phthalocyanin (C.I. 74160) | 1,2 % |

Eine 17%ige Lösung in Methylenchlorid wurde wie in Beispiel 1 zur elastomeren Schicht c) verarbeitet. Die Herstellung und die weitere Verarbeitung der so hergestellten Druckplatte erfolgte wie in Beispiel 1 beschrieben. Die Photoempfindlichkeit, der Belichtungsspielraum und das Entwicklungsverhalten entsprach Druckplatten gemäß dem Stand der Technik. Die Druckplatte zeichnete sich durch eine verbesserte Ozonstabilität aus. Die Oberfläche der photopolymerisierbaren Druckplatte war nicht klebrig, so daß die Belichtungsvorlage ohne Probleme nach der Belichtung entfernt werden konnte. Sie war völlig unbeschädigt und sauber und zur Wiederverwendung geeignet. Die Oberfläche der so hergestellten Flexodruckform war vollständig intakt, zeigte keine Faltenbildung und keine Quellung mit den verwendeten Druckfarben.

### Beispiel 3

### Zusammensetzung der elastomeren Schicht c)

| | |
|---|---|
| Radiales (Polystyrol-Polybutadien)₄-Si-Blockcopolymer, 20 % Polystyrol, Lösungsviskosität 19 mm²/s (5,23%ig in Toluol), Schmelzindex < 0,5 g/10 min (gemäß ASTM D 1238 P) | 50 % |
| Methylmethacrylat/Acrylnitril/Butadien/Styrol Tetrapolymer, 46/9/14/31, Trübung 10 %, (gemäß ASTM D 1003), Rockwell Härte 103 (gemäß ASTM 785) | 49 % |
| Ein in Didecylphthalat dispergiertes Cu-Phthalocyanin (C.I. 74160) | 1 % |

Das Tetrapolymer wurde in Toluol/Methylethylketon (4:1) aufgelöst und die Lösung filtriert. Aus dieser Lösung und den übrigen Komponenten wurde eine 20 %ige Gießlösung hergestellt. Die Herstellung der elastomeren Schicht und alle weiteren Verarbeitungsschritte erfolgten wie in Beispiel 2. Die Photoempfindlichkeit, der Belichtungsspielraum und das Entwicklungsverhalten entsprach Druckplatten gemäß dem Stand der Technik.Die Druckplatte zeichnete sich durch eine verbesserte Ozonstabilität aus. Die Oberfläche der photopolymerisierbaren Druckplatte war nicht klebrig, so daß die Belichtungsvorlage ohne Probleme nach der Belichtung entfernt werden konnte. Sie war völlig unbeschädigt und sauber und zur Wiederverwendung geeignet. Die Oberfläche der so hergestellten Flexodruckform war vollständig intakt, zeigte keine Faltenbildung und keine Quellung mit den verwendeten Druckfarben.

### Beispiel 4

### Zusammensetzung der elastomeren Schicht c

| | |
|---|---|
| radiales (Poylystyrol-Polybutadien) ₄-Si-Blockcopolymer 20 % Polystyrol, Lösungsviskosität 19 mm²/s (5.23 %ig in Toluol), Schmelzindex < 0,5 g/10 min (gemäß ASTM D 1238 P) | 45,2 % |
| Methylmethacrylat/Acrylnitril/Butadien/Styrol (46/9/14/31), Trübung 10 % (gemäß ASTM D 1003), Rockwell Härte 103 (gemäß ASTM 785) | 45,2 % |
| Ein in Didecylphthalat dispergiertes Cu-Phthalocyanin (C.I. 74160) | 0,6 % |
| Acrylsäure modifiziertes, mit Glycerin teilweise verestertes Kolophoniumharz (Säurezahl 220 - 250, Viskosität ca. 17 mPa s bei 20 °C, 50%ig in Ethanol) | 5,0 % |
| Bisphenol-A-Epichlorhydrin-Epoxidharz (Epoxid-Äquivalentgewicht 182 - 194 g, Viskosität 9 - 14 Pa s bei 25 °C (nach ASTM D 445) | 4,0 % |

Die Herstellung der Gießlösung und der elastomeren Schicht und alle weiteren Verarbeitungsschritte erfolgten wie in Beispiel 2. Die Photoempfindlichkeit, der Belichtungsspielraum und das Entwicklungsverhalten entsprach Druckplatten gemäß dem Stand der Technik. Die Druckplatte zeichnete sich durch eine verbesserte Ozonstabilität aus. Die Oberfläche der photopolymerisierbaren Druckplatte war nicht klebrig, so daß die Belichtungsvorlage ohne Probleme nach der Belichtung entfernt werden konnte. Sie war völlig unbeschädigt und sauber und zur Wiederverwendung geeignet. Die Oberfläche der so hergestellten Flexodruckform war vollständig intakt, zeigte keine Faltenbildung und keine Quellung mit den verwendeten Druckfarben.

## Patentansprüche

1. Photopolymerisierbare Druckplatte im wesentlichen bestehend aus
a) einem Schichtträger,
b) einer photopolymerisierbaren Schicht enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem,
c) einer elastomeren Schicht enthaltend mindestens ein thermoplastisch elastomeres Blockcopolymer
und
d) einer Deckfolie,
dadurch gekennzeichnet, daß
die elastomere Schicht c) als Bindemittel ein oder mehrere thermoplastisch elastomere Blockcopolymere enthält, die aufgebaut sind aus mindestens einem Polystyrolblock und mindestens einem Polybutadien-, Polyethylen- und/oder Polypropylenblock wobei der Polystyrolgehalt des Bindemittels oder des Bindemittelgemischs 10 bis 35 Gew.% beträgt, die Lösungsviskosität der Blockcopolymere für eine 5,23%ige Lösung in Toluol ≥ 5 mm²/s und der Schmelzindex gemessen nach ASTM D 1238 P ≤ 10 g/10 min ist.

2. Photopolymerisierbare Druckplatte nach Anspruch 1
dadurch gekennzeichnet, daß
ein Polystyrol-Polybutadien- oder Polystyrol-Polybutadien-Polystyrolblockcopolyymer mit einem Polystyrolgehalt von 15 bis 30 Gew.%, einer Lösungsviskosität von ≥ 10 mm²/s und einem Schmelzindex ≤ 2 g/10 min enthält.

3. Photopolymerisierbare Druckplatte nach Anspruch 1 oder 2
dadurch gekennzeichnet, daß
die elastomere Schicht c) ein radiales (Polystyrol-Polybutadien)₄-Si-Blockcopolymer mit einem Polystyrolgehalt von 18 bis 23 Gew.%, einer Lösungsviskosität von ≥ 15 mm²/s und einem Schmelzindex ≤ 1,5 g/10 min enthält.

4. Photopolymerisierbare Druckplatte nach Anspruch 1 bis 3
dadurch gekennzeichnet, daß
die elastomere Schicht c) 30 bis 70 Gew.% eines Polymers enthält mit einer Trübung gemessen nach ASTM D 1009 von ≤ 20 % und einer Rockwell Härte gemessen nach ASTM D 785 von ≥ 50.

5. Photopolymerisierbare Druckplatte nach Anspruch 1 bis 4
dadurch gekennzeichent, daß
die elastomere Schicht c) 40 bis 60 Gew.% eines Polymers enthält mit einer Trübung gemessen nach ASTM D 1009 von ≤ 12 % und einer Rockwell Härte gemessen nach ASTM D 785 von ≥ 80.

6. Verfahren zur Herstellung der elastomeren Schicht c) einer photopolymerisierbaren Druckplatte gemäß Anspruch 4 oder 5
dadurch gekennzeichnet, daß
das Polymer gemäß Anspruch 4 oder 5 im Lösungsmittel für die Gießlösung aufgelöst und diese Lösung filtriert wird und dann aus den übrigen Komponenten und der so vorbehandelten Lösung des Polymeren die Gießlösung für die elastomere Schicht c) hergestellt wird.

7. Verfahren zur Herstellung photopolymerisierbarer Druckplatten, bei dem in den Spalt eines Kalanders eine photopolymerisierbare Masse aus mindestens einem Strahlung additionspolymerisierbaren, ethylenisch ungesättigten Monomer und einem Photoinitiator oder einem Photoinitiatorsystem eingeführt und zwischen einen Träger a) und ein mehrschichtiges Deckelement kalandriert wird und die photopolymerisierbare Schicht b) zwischen ihnen gebildet wird, wobei das mehrschichtige Deckelement aus einer elastomeren Schicht c) enthaltend mindestens ein thermoplastisch elastomeres Blockcopolymer, und einer Deckfolie d) besteht
dadurch gekennzeichnet, daß
die elastomere Schicht c) als Bindemittel ein oder mehrere thermoplastisch elastomere Blockcopolymere enthält, die aufgebaut sind aus mindestens einem Polystyrolblock und mindestens einem Polybutadien-, Polyethylen- und/oder Polypropylenblock wobei der Polystyrolgehalt des Bindemittels oder des Bindemittelgemischs 10 bis 35 Gew.% beträgt, die Lösungsviskosität der Blockcopolymere für eine 5,23%ige Lösung in Toluol ≥ 5 mm²/s und der Schmelzindex gemessen nach ASTM D 1238 P ≤ 10 g/10 min ist.

8. Verfahren zur Herstellung von flexographischen Druckformen umfassend
1) das bildmäßige Belichten mit aktinischer Strahlung einer photopolymerisierbaren Druckplatte gemäß Anspruch 1 bis 5 durch die elastomere Schicht c)
2) das Entfernen der unbelichteten Bereiche der photopolymerisierbaren Schicht b) und der elastomeren Schicht c) durch Auswaschen mit Entwicklerlösungsmitteln.

## Claims

1. A photopolymerizable printing element consisting essentially of
a) a support;
b) a photopolymerizable layer containing at least one elastomeric binder, at least one ethylenically unsaturated monomer addition-polymerizable by actinic radiation, and a photoinitiator or photoinitiator system;
c) an elastomeric layer containing at least one thermoplastic, elastomeric block copolymer; and
d) a cover sheet
characterized in that,
the elastomeric layer c) contains as a binder, one or more thermoplastic, elastomeric block copolymers, made up of at least one polystyrene block and at least one polybutadiene, polyethylene and/or polypropylene block, wherein the binder or binder mixture has a polystyrene content of 10 to 35 percent by weight, the solution viscosity of the block copolymers for a 5.23% solution in toluene is ≥ 5 mm²/s, and the melt index measured according to ASTM D 1238 P is ≤ 10 g /10 min.

2. A photopolymerizable printing element according to Claim 1,
characterized in that,
the elastomeric layer c) contains a polystyrene-polybutadiene or polystyrene-polybutadiene-polystyrene block copolymer having a polystyrene content of 15 to 30 percent by weight, a solution viscosity ≥ 10 mm²/s, and a melt index ≤ 2 g/10 min.

3. A photopolymerizable printing element according to Claim 1 or 2,
characterized in that,
the elastomeric layer c) contains a radial (polystyrene-polybutadiene)₄Si block copolymer having a polystyrene content of 18 to 23 percent by weight, a solution viscosity ≥ 15 mm²/s, and a melt index ≤ 1.5 g/10 min.

4. A photopolymerizable printing element according to Claim 1 - 3,
characterized in that,
the elastomeric layer c) contains 30 to 70 percent by weight of a polymer having a turbidity measured according to ASTM D 1003 ≤ 20% and a Rockwell hardness measured accoring to ASTM D 785 ≥ 50.

5. A photopolymerizable printing element according to Claim 1 - 4,
characterized in that,
the elastomeric layer c) contains 40 to 60 percent by weight of a polymer having a turbidity measured according to ASTM D 1003 ≤ 12 and a Rockwell hardness measured according to ASTM D 785 ≥ 80.

6. A process for preparing the elastomeric layer c) of a photopolymerizable printing element according to claim 4 or 5,
characterized in that,
the polymer according to claim 4 or 5 is dissolved in the solvent for the coating solution and this solution is filtered and then the coating solution for the elastomeric layer c) is made up from the remaining components and the in such a way pretreated solution.

7. A process for preparing photopolymerizable printing elements comprising feeding into the nip of a calender a photopolymerizable composition containing at least one elastomeric binder, at least one ethylenically unsaturated monomer addition-polymerizable by actinic radiation and a photoinitiator or a photoinitiator system, calendering the composition between a support a) and a multilayer cover element to form the photopolymerizable layer b) between them, wherein the multilayer cover element consists of an elastomeric layer c) containing at least one thermoplastic, elastomeric block copolymer, and a cover sheet d)
characterized in that,
the elastomeric layer c) contains as a binder, one or more thermoplastic, elastomeric block copolymers, made up of at least one polystyrene block and at least one polybutadiene, polyethylene and/or polypropylene block, wherein the binder or binder mixture has a polystyrene content of 10 to 35 percent by weight, the solution viscosity of the block copolymers for a 5.23% solution in toluene is ≥ 5 mm²/s, and the melt index measured according to ASTM D 1238 P is ≤ 10 g /10 min.

8. A process for preparing flexographic printing plates comprising:
1) exposing imagewise with actinic radiation the photopolymerizable printing element of Claim 1 - 5 through the elastomeric layer c); and
2) removing the unexposed areas of the photopolymerizable layer b) and of the elastomeric layer c) by washoff with developer solvents.

## Revendications

1. Cliché photopolymérisable constitué essentiellement de :
a) d'un porteur de couche,
b) une couche photopolymérisable contenant au moins un liant élastomère, au moins un monomère éthyléniquement insaturé susceptible de polymériser addition sous l'action d'un rayonnement actinique et un photoinitiateur ou système photoinitiateur;
c) une couche élastomère contenant au moins un copolymère en bloc élastomère thermoplastique ; et
d) un film de recouvrement,
caractérisé en ce que la couche élastomère c) contient en tant que liant un ou plusieurs copolymères séquencés élastomères thermoplastiques, constitués à partir d'au moins un bloc polystyrène et au moins un bloc polybutadiène-polyéthylène et/ou polypropylène, et dans lequel la teneur en polystyrène du liant ou du mélange de liant est de 10 à 35 % en poids, la viscosité en solution des copolymères séquencés d'une solution à 5,23 % dans du toluène est ≥ à 5 mm²/s et l'indice de fusion mesuré selon ASTM D 1238 P est ≤ 10 g/10 minutes.

2. Cliché photopolymérisable selon la revendication 1, caractérisé en ce qu'il contient un copolymère séquencé polystyrène-polybutadiène ou polystyrène-polybutadiène-polystyrène ayant une teneur en polystyrène de 15 à 30 % en poids, une viscosité en solution ≥ à 10 mm²/s et un indice de fusion ≤ 2 g/10 minutes.

3. Cliché photopolymérisable selon la revendication 1 ou 2, caractérisé en ce que la couche élastomère c) contient un copolymère séquencé radial (polystyrène-polybutadiène)₄-Si ayant une teneur en polystyrène de 18 à 23 % en poids. une viscosité en solution ≥ à 15 mm²/s et un indice de fusion ≤ 1,5 g/10 minutes.

4. Cliché photopolymérisable selon les revendications 1 à 3, caractérisé en ce que la couche élastomère c) contient 30 à 70 % en poids d'un polymère ayant une turbidité mesurée selon ASTM D 1009 ≤20 % et une dureté Rockwell mesurée selon ASTM D 785 ≥ à 50

5. Cliché photopolymérisable selon les revendications 1 à 4, caractérisé en ce que la couche élastomère c) contient 40 à 60 % en poids d'un polymère ayant une turbidité mesurée selon ASTM D 1009 ≤ 12 % et une dureté Rockwell mesurée selon ASTM D 785 ≥ à 80

6. Procédé de fabrication d'une couche élastomère c) d'un cliché polymérisable selon la revendication 4 ou 5, caractérisé en ce que le polymère selon la revendication 4 ou 5 est dissout dans le solvant pour la solution de coulée et que cette solution est filtrée, et qu'ensuite la solution de coulée pour la couche élastomère c) est fabriquée à partir des autres composants et de la solution du polymère ainsi prétraité.

7. Procédé de fabrication de cliché photopolymérisable dans lequel une masse photopolymérisable d'au moins un monomère éthyléniquement insaturé. susceptible de polymériser par addition sous l'action d'un rayonnement et un photoinitiateur ou un système de photoinitiateur, est introduite dans la fente d'une calandre et est calandrée entre un support a) et un élément de recouvrement multicouches, et dans lequel la couche photopolymérisable b) est formée entre eux. et dans lequel procédé l'élément de recouvrement multicouches est constitué d'une couche élastomère c) contenant au moins un copolymères séquencé,
caractérisé en ce que la couche élastomère c) contient en tant que liant un ou plusieurs copolymères séquencés élastomères thermoplastiques, qui sont constitués d'au moins un bloc polystyrène et d'au moins un bloc polybutadiène, polyéthylène et/ou polypropylène, et en ce que la teneur en polystyrène du liant ou du mélange de liant est de 10 à 35 % en poids, la viscosité de la solution des copolymères séquencés d'une solution à 5,23 % dans du toluène est ≥ à 5 mm²/s et l'indice de fusion mesuré selon ASTM D 1238 P est ≤ 10 g/10 minutes.

8. Procédé de fabrication de formes d'impression flexographiques comprenant :
1) l'exposition, à la façon dont on forme une image d'un cliché photopolymérisable selon les revendications 1 à 5 à travers la couche élastomère c) :
2) l'élimination des zones non exposées de la couche photopolymérisable b) et de la couche élastomère c) par lavage avec des solvants de développement.
